(19) **Europäisches Patentamt / European Patent Office / Office européen des brevets**

(11) **EP 4 199 250 B1**

(12) **EUROPEAN PATENT SPECIFICATION**

(45) Date of publication and mention
of the grant of the patent:
**05.08.2026 Bulletin 2026/32**

(21) Application number: **21868129.4**

(22) Date of filing: **14.05.2021**

(51) International Patent Classification (IPC):
**H10W 44/20** (2026.01)   **H01P 5/107** (2006.01)
**H01P 5/08** (2006.01)   **H04B 1/40** (2015.01)
**H01Q 9/04** (2006.01)   **H01Q 1/22** (2006.01)

(52) Cooperative Patent Classification (CPC):
**H01Q 9/0457; H01P 5/087; H01P 5/107;
H01Q 1/2283; H04B 1/40; H10W 44/20;**
H10W 44/216; H10W 44/219; H10W 44/248

(86) International application number:
**PCT/CN2021/093770**

(87) International publication number:
**WO 2022/057291 (24.03.2022 Gazette 2022/12)**

(54) **RADIOFREQUENCY CHIP, SIGNAL TRANSCEIVER, AND COMMUNICATION DEVICE**

HOCHFREQUENZCHIP, SIGNALSENDER-EMPFÄNGER UND
KOMMUNIKATIONSVORRICHTUNG

PUCE RADIOFRÉQUENCE, ÉMETTEUR-RÉCEPTEUR DE SIGNAL ET DISPOSITIF DE
COMMUNICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.09.2020 CN 202010975335**

(43) Date of publication of application:
**21.06.2023 Bulletin 2023/25**

(73) Proprietor: **Huawei Technologies Co., Ltd.
Shenzhen, Guangdong 518129 (CN)**

(72) Inventors:
• **ZHANG, Luqi
Shenzhen, Guangdong 518129 (CN)**

• **LI, Kun
Shenzhen, Guangdong 518129 (CN)**
• **TANG, Xianfeng
Shenzhen, Guangdong 518129 (CN)**
• **LUO, Yanxing
Shenzhen, Guangdong 518129 (CN)**

(74) Representative: **Thun, Clemens
Mitscherlich PartmbB
Karlstraße 7
80333 München (DE)**

(56) References cited:
**EP-A1- 1 367 668       CN-A- 109 244 642
CN-A- 111 128 971       US-A1- 2012 208 320
US-A1- 2017 324 135**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## TECHNICAL FIELD

Embodiments of this application relate to the communication field, and more specifically, to a radio frequency chip, a signal transceiver, and a communication device.

## BACKGROUND

With development of information technologies, a requirement for a transmission rate between devices is increasingly high. For example, a large quantity of high-speed cables need to be arranged between cabinets and inside cabinets in a data center to implement high-speed data transmission. Currently, high-speed cables mainly include active optical cables and direct attach copper cables. When an active optical cable is used, an electrical signal needs to be converted into an optical signal, or an optical signal needs to be converted into an electrical signal; and optical transceivers at two ends of the active optical cable need to provide optical-to-electrical conversion and optical transmission functions, resulting in high power consumption and high costs. When a direct attach copper cable is used, no electrical-to-optical or optical-to-electrical conversion process needs to be performed, and an electrical signal is directly transmitted. Therefore, power consumption and costs are low. However, as an operating frequency increases, a metal loss of the direct attach copper cable increases, which limits a transmission distance and rate of the direct attach copper cable. In addition, the copper cable has a large weight and bending radius, which is not conducive to application in a dense cabling scenario.

In view of this, a terahertz active cable technology is provided, that is, a terahertz wave is used as a carrier and a polymer transmission line is used as a transmission medium. Compared with direct attach copper cables and optical fibers, polymer transmission lines have advantages of low loss, light weight, and low costs.

However, how to couple a terahertz signal (or a terahertz modulation signal) output by a chip to the polymer transmission line is a key problem.
The document EP 1 367 668 A1 shows a broadband microstrip to waveguide transition on a multilayer printed circuit board.
The document US 2017/0324135 A1 shows a microwave antenna apparatus, and an according packing and manufacturing method.

## SUMMARY

The present invention is defined by the independent claims. Further advantageous developments are shown by the dependent claims.

This application provides a radio frequency chip, a signal transceiver, and a communication device, so that a coupling structure used to couple a signal to a polymer transmission cable can be integrated into a chip, thereby improving coupling efficiency.

According to a first aspect, a radio frequency chip is provided, including: a chip 200, configured to generate an electromagnetic signal or process an electromagnetic signal; a coupling structure 100, including: a resonator 110, where a resonant cavity 112 and a groove 114 are formed, an inner wall of the resonant cavity 112 is made of metal, one end of the resonant cavity 112 is opened on a top surface 1102 of the resonator 110, the other end of the resonant cavity 112 is sealed by using a metal material, a cross section of the resonant cavity 112 is formed into a centro-symmetric shape, and the groove 114 connects an outer wall of the resonator 110 and an inner wall of the resonant cavity 112; a redistribution layer RDL 120, arranged above the top surface 1102 and including an RDL dielectric layer 124; a radiator 130, made of metal, formed into a centro-symmetric shape, arranged on a surface that is of the RDL dielectric layer 124 and that faces the resonator 110, and accommodated in the resonant cavity 112; a feeder 140, accommodated in a groove 114, where one end is connected to the chip 200, and the other end is inserted into the resonant cavity 112; and a packaging structure 300, configured to package the chip 200 and cover the redistribution layer RDL 120, where a through hole 310 for accommodating a metal connector is formed on the packaging structure 300, one end of the metal connector is in contact with a surface that is of the RDL 120 and that faces away from the resonator 110, the other end of the metal connector is configured to connect to a polymer transmission cable, and a cross section of the through hole 310 is formed into a centro-symmetric shape; a symmetry center of the radiator 130, a symmetry center of the resonant cavity 112, and a symmetry center of the through hole 310 are coaxially arranged, and a deviation between cross-sectional sizes of the through hole 310 and the resonant cavity 112 is within a first preset range.

According to the solution provided in this application, a centro-symmetric radiator is designed at the redistribution layer of the chip, and a through hole for embedding the metal connector is arranged on the packaging structure of the chip, so that a signal generated by the chip can be efficiently coupled to the polymer transmission line. Because the foregoing structure is packaged in the chip, an insertion loss generated due to a connection line arranged between the chip and the coupling structure can be reduced, thereby improving coupling efficiency; and integration between the chip and the coupling structure can be improved, thereby facilitating large-scale processing.

The electromagnetic signal includes a terahertz (Tera Hertz, THz) signal, or may also be referred to as a THz modulation signal.
"a radiator 130, formed into a centro-symmetric shape" may be understood as that the radiator 130 includes a plurality of resonant arms, and the plurality of resonant arms are centro-symmetrically arranged.

Central symmetry (central symmetry) means that if a figure can coincide with another figure after being rotated 180° around a point, the two figures are considered to be symmetric or centro-symmetric with respect to the point.

In this application, the groove 114 may be arranged on one side wall of the resonator 110, and the groove 114 may penetrate a part or all of the side wall in a height direction. This is not particularly limited in this application.

In this application, the redistribution layer RDL 120 may further include an RDL bottom metal layer and an RDL top metal layer; and an RDL dielectric layer 124 is located between the RDL bottom metal layer and the RDL top metal layer.

In addition, for the RDL bottom metal layer 122 and the RDL top metal layer 126, the RDL bottom metal layer 122 is arranged on the top surface 1102 of the resonator 110, and a hole 1221 is arranged at the RDL bottom metal layer 122. A size of the hole 1221 is corresponding to a cross-sectional size of the resonant cavity 112, a hole 1226 is arranged at the RDL top metal layer 126, and a size of the hole 1226 is corresponding to a cross-sectional size of the resonant cavity 112. A symmetry center of the hole 1226, a symmetry center of the hole 1221, the symmetry center of the radiator 130, the symmetry center of the resonant cavity 112, and the symmetry center of the through hole 310 are coaxially arranged.

In this application, a deviation between a depth of the resonant cavity 112 and a first value is within a second preset range, and the first value is a quarter of a wavelength of the electromagnetic signal.

In this application, the feeder 140 is inserted into the resonant cavity 112 in a first direction, and a length L1 of the first part of the resonant cavity 112 in which the feeder 140 is inserted is determined based on a length L2 of the radiator 130 in the first direction and a length L3 of the resonant cavity 112 in the first direction.

Alternatively, L2 is determined based on L1 and L3.

Alternatively, L3 is determined based on L1 and L2

The length L1, the length L2, and the length L3 meet the following relationship: $L1+0.5\times L2<0.5\times L3$.

In an implementation, the resonator 110 is made of a waveguide material.

In this case, a metal covering layer is arranged on the inner wall of the resonant cavity.

In this application, an operating frequency f of the waveguide material is corresponding to a cross-sectional diameter D1 of the metal connector.

For example, the operating frequency f and the cross-sectional diameter D1 meet the following relationship: $f\geq 1.841c/2\times\pi\times D1$,

where c represents the speed of light.

In this application, the depth of the resonant cavity 112 is greater than or equal to a sum of a second value and a third value, where the second value is a depth of a recessed structure that is in a printed circuit board (Printed Circuit Board, PCB) and that is configured to accommodate the coupling structure 100, and the second value is a height of a solder ball in the PCB.

In an implementation, a cross section of the resonant cavity 112 and a cross section of the metal connector are circular, and a deviation between a diameter of the resonant cavity and the diameter of the metal connector is within a third preset range.

By way of example and not limitation, the radiator 130 is formed into one of a cross structure, a double-X-shaped structure, an X-shaped structure, a rectangular ring shaped structure, or a 2x2 grid structure.

In an implementation, the resonant cavity 112 is specifically a semi-through hole formed on the resonator 110, where a metal covering layer is arranged on an inner wall and a bottom surface of the semi-through hole.

In another implementation, the resonant cavity 112 is specifically a through hole formed on the resonator 110.

In this case, a metal plate is arranged on a bottom surface of the resonator 110, and the metal plate seals an opening that is of the through hole and that is located on the bottom surface.

Alternatively, a metal plate is arranged on a PCB configured to arrange the radio frequency chip, and the metal plate is configured to seal an opening that is of the through hole and that is located on the bottom surface.

According to a second aspect, a signal transceiver is provided, including: the radio frequency chip according to any one of the first aspect or the possible implementations of the first aspect; and a printed circuit board PCB, configured to arrange the radio frequency chip.

In an implementation, a recessed structure is arranged on the PCB, and is configured to accommodate the radio frequency chip, where

the recessed structure is a through hole; or
the recessed structure is a groove.

In another implementation, the signal transceiver further includes the metal connector.

In still another implementation, the signal transceiver further includes the polymer transmission cable.

According to a third aspect, a communication device is provided, including the signal transceiver according to any one of the second aspect or the possible implementations of the second aspect.

According to a fourth aspect, a communication cable is provided, including a polymer transmission cable; the radio frequency chip according to any one of the first aspect or the possible implementations of the first aspect; a metal connector, accommodated in the through hole 310 of the packaging structure 300 of the radio frequency chip, where one end of the metal connector is in contact with a surface that is of the RDL 120 and that faces away from the resonator 110, and the other end of the metal connector is configured to connect to a polymer transmission cable.

According to a fifth aspect, a server is provided, where each server includes at least one signal transceiver according to any one of the second aspect or the possible implementations of the second aspect.

According to a sixth aspect, a data processing system is provided, including a plurality of servers, where each server includes at least one signal transceiver according to any one of the second aspect or the possible implementations of the second aspect.

## BRIEF DESCRIPTION OF DRAWINGS

FIG. 1 is a schematic diagram of a structure of an example of a radio frequency chip according to this application;

FIG. 2 is a three-dimensional exploded view of a radio frequency chip according to this application;

FIG. 3 is a dimension diagram of components of a radio frequency chip according to this application;

FIG. 4 is a schematic diagram of an example of a resonator according to this application;

FIG. 5 is a schematic diagram of another example of a resonator according to this application;

FIG. 6 is a schematic diagram of an example of a radiator according to this application;

FIG. 7 is a schematic diagram of another example of a structure of a radiator according to this application;

FIG. 8 is a schematic diagram of still another example of a structure of a radiator according to this application;

FIG. 9 is a schematic diagram of still another example of a structure of a radiator according to this application;

FIG. 10 is a schematic diagram of still another example of a structure of a radiator according to this application;

FIG. 11 is a schematic diagram of an example of an arrangement manner of a radio frequency chip on a PCB according to this application;

FIG. 12 is a schematic diagram of another example of an arrangement manner of a radio frequency chip on a PCB according to this application;

FIG. 13 is a schematic diagram of a relationship between a reflection parameter and a frequency of a radio frequency chip according to this application;

FIG. 14 is a schematic diagram of a relationship between transmission energy and a frequency of a radio frequency chip according to this application;

FIG. 15 is a schematic diagram of electric field distribution of a coupling structure according to this application;

FIG. 16 is a schematic diagram of an example of a signal transceiver to which a radio frequency chip according to this application is applicable;

FIG. 17 is a schematic diagram of a structure of an example of a data center cabinet to which a radio frequency chip according to this application is applicable; and

FIG. 18 is a schematic diagram of a structure of an example of a data center system to which a radio frequency chip according to this application is applicable.

## DESCRIPTION OF EMBODIMENTS

The following describes technical solutions of this application with reference to accompanying drawings.

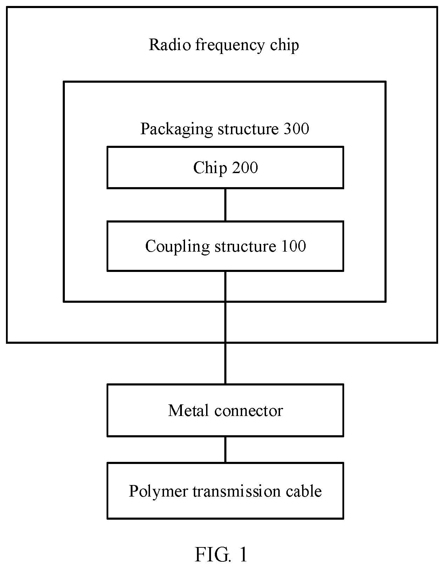

FIG. 1 is a schematic diagram of a structure of an example of a radio frequency chip according to this application. As shown in FIG. 1, the radio frequency chip according to this application includes a chip 200, a coupling structure 100, and a packaging structure 300.

The chip 200 is configured to generate an electromagnetic signal that needs to be sent to the outside, and/or the chip 200 is configured to process an electromagnetic signal from the outside.

By way of example and not limitation, the electromagnetic signal may include, but is not limited to, a terahertz (Tera Hertz, THz) signal.

The THz signal may also be referred to as a THz modulation signal, and is a signal carried on a terahertz wave.

A terahertz wave is an electromagnetic wave with a frequency in the range of 0.1-10 THz (wavelength 3000-30 $\mu$m), which coincides with a millimeter wave on a long wavelength band and coincides with infrared light on a short wavelength band. The terahertz wave is a transition region from a macroscopic classical theory to a microscopic quantum theory, and is also a transition region from electronics to photonics, and is referred to as a THz gap of the electromagnetic spectrum.

Processes of generating and processing an electromagnetic signal by the chip 200 may be similar to those in a conventional technology. To avoid repetition, detailed descriptions are omitted herein.

The coupling structure 100 is configured to couple an electromagnetic signal generated by the chip 200 to a metal connector, and then transmit the electromagnetic signal to an external device through a polymer transmission cable connected to the metal connector.

In addition, the coupling structure 100 is configured to couple an electromagnetic signal that is input from an external device to the chip 200 through the polymer transmission cable and the metal connector.

The polymer transmission cable is of a solid-core structure, and a material includes, but is not limited to, polytetrafluoroethylene. In addition, ends of the polymer transmission cable are formed into a tapered gradient structure, so as to be inserted into the metal connector.

In addition, to ensure alignment between the polymer transmission cable and the metal connector, the polymer transmission cable and the metal connector are coaxially arranged, and a diameter Od of the polymer transmission cable and a diameter Cd of the metal connector meet the following relationship: Cd≤Od

It should be understood that the foregoing listed connection relationship between the metal connector and the polymer transmission line is merely an example for description, and this application is not limited thereto. In addition, structures and materials of the metal connector and the polymer transmission line may also be similar to those in the conventional technology. This is not particularly limited in this application.

The packaging structure 300 is configured to package the chip 200 and the coupling structure 100, to form an integrated radio frequency chip.

Specifically, the packaging structure 300 covers the redistribution layer RDL 120 of the coupling structure 100 (the component is subsequently described in detail), and a through hole 310 for accommodating the metal connector is formed on the packaging structure 300, where a shape of the through hole 310 is corresponding to a shape of the metal connector. For example, the through hole 310 (specifically, a cross section of the through hole 310) is formed as a circle. In addition, a symmetry center of the through hole 310 and a symmetry center of the metal connector are coaxially arranged. That is, an axis of the through hole 310 and an axis of the metal connector are coaxially arranged. In addition, a size of the through hole 310 is corresponding to a size of the metal connector. For example, a diameter of the through hole 310 is the same as or approximately the same as a diameter of the metal connector.

The following describes in detail a structure and an arrangement of the coupling structure 100 in this application.

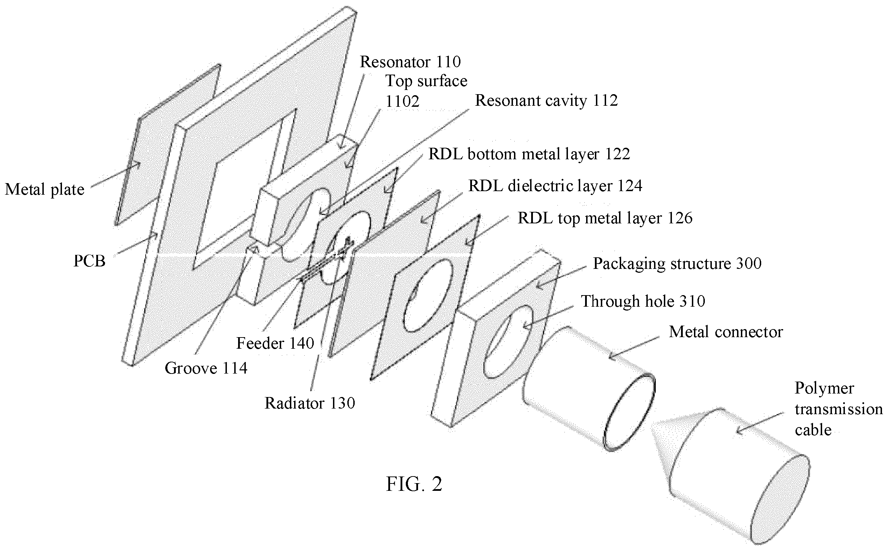

FIG. 2 is a three-dimensional exploded view of a radio frequency chip according to this application. As shown in FIG. 2, a coupling structure 100 includes a resonator 110, a redistribution layer RDL 120, a radiator 130, and a feeder 140.

The following separately describes in detail structures and arrangements of the foregoing components.

A. Resonator 110

As shown in FIG. 2 to FIG. 5, a resonant cavity 112 and a groove 114 are formed on the resonator 110.

A shape of the resonant cavity 112 is a centrosymmetric shape.

In addition, a shape of the resonant cavity 112 is corresponding to a shape of the metal connector.

For example, the resonant cavity 112 (specifically, a cross section of the resonant cavity 112) is formed as a circle.

In addition, a symmetry center of the resonant cavity 112 and a symmetry center of the metal connector are coaxially arranged.

That is, an axis of the resonant cavity 112 and an axis of the metal connector are coaxially arranged.

In addition, a size of the resonant cavity 112 is corresponding to a size of the metal connector.

In this application, a side wall of the resonant cavity 112 is covered with a metal material (for example, in a manner of electroplating, vapor deposition, or sputtering).

The side wall of the resonant cavity 112 may also be referred to as an inner wall of the resonant cavity 112 or an inner wall of the resonator 110.

In this application, the resonant cavity 112 includes an open end and a closed end, and the closed end is closed (or sealed or covered) by using a metal material.

The open end of the resonant cavity 112 is arranged on the top surface 1102 of the resonator 110, that is, the resonant cavity 112 is opened on the top surface 1102 of the resonator 110.

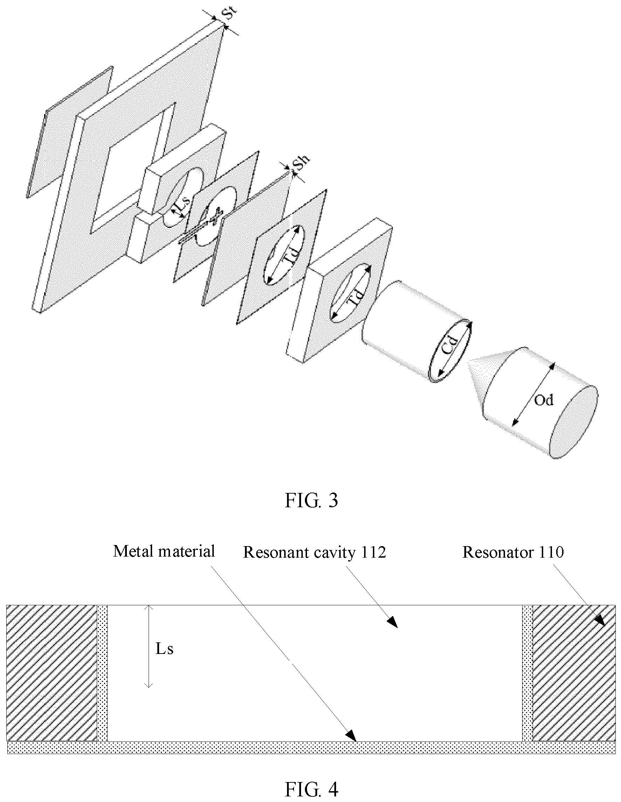

FIG. 4 is a schematic sectional view of an example of a structure of the resonator 110 according to this application. As shown in FIG. 2 and FIG. 4, the resonant cavity 112 may be formed by arranging a through hole on the resonator 110.

In this case, a metal plate may be arranged on a bottom surface of the resonator 110 as a metal material used to seal the closed end.

Alternatively, the radio frequency chip in this application needs to be arranged on the PCB when being used.

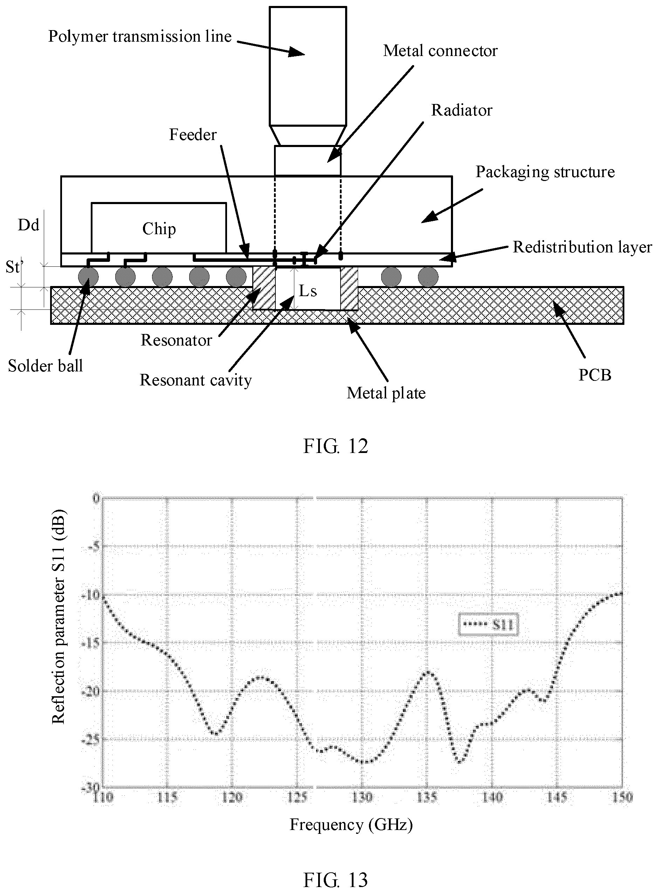

For example, as shown in FIG. 12, a groove for accommodating the resonator 110 may be arranged on the PCB, and a metal material is covered on a bottom surface of the groove (for example, in a manner of electroplating, vapor deposition, or sputtering), so that when the radio frequency chip is arranged on the PCB, the resonator 110 is accommodated in the groove of the PCB. Therefore, the closed end can be sealed by using the metal material covering the bottom surface of the groove.

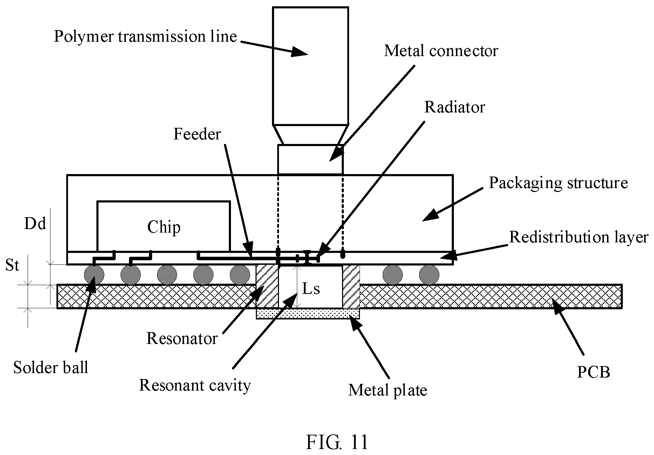

For another example, as shown in FIG. 11, a through hole for accommodating the resonator 110 may be arranged on the PCB, and a metal plate is arranged at a position that is on a bottom surface of the PCB and that is corresponding to the through hole. Therefore, when the radio frequency chip is arranged on the PCB, the resonator 110 is accommodated in the groove of the PCB, so that the closed end can be sealed by using the metal plate.

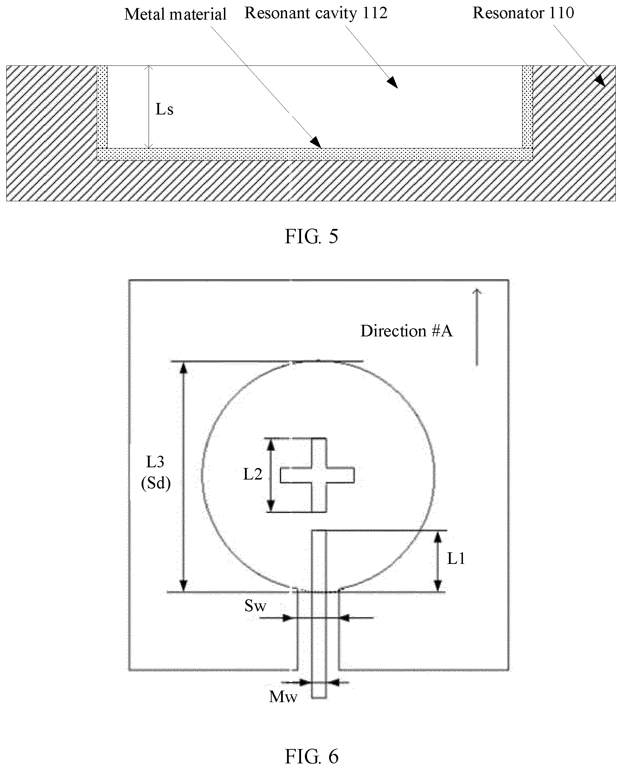

FIG. 5 is an example sectional view of another example of a structure of the resonator 110 according to this application. As shown in FIG. 5, the resonant cavity 112 may be formed by arranging a groove on the resonator 110. In this case, the bottom surface of the groove may be covered with a metal material (for example, in a manner of electroplating, vapor deposition, or sputtering).

The groove 114 is arranged on one side wall of the resonator 110, and is configured to connect an outer wall of the resonator 110 and a side wall of the resonant cavity 112. In this application, a width of the groove 114 is not particularly limited in this application, provided that the feeder 140 described below can pass through.

As shown in FIG. 2 and FIG. 4, the groove 114 may be formed as a groove that penetrates the top surface and the bottom surface of the resonator 110.

Alternatively, as shown in FIG. 5, the groove 114 may be formed as a groove that penetrates neither the top surface nor the bottom surface of the resonator 110.

In this application, a material of the resonator 110 may be a waveguide material, for example, lithium niobate (LiNbO3), an III-V semiconductor compound, silicon dioxide (SiO2), silicon-on-insulator (Silicon-on-Insulator, SOI), a polymer (Polymer), or glass.

That is, the resonator 110 may be a waveguide (or an optical waveguide).

FIG. 3 is a dimension diagram of components of a radio frequency chip according to this application. As shown in FIG. 3, a diameter of the resonant cavity 112 is Ld, a diameter of the metal connector is Cd, and a depth of the resonant cavity 112 is Ls.

In this case, the relationship between Ld and Cd meets: Ld is the same as or approximately the same as Cd, that is, a deviation between Ld and Cd is within a preset range (which can be set according to a specific application scenario or application requirement), that is: Ld=Cd, or Ld≈Cd. In addition, there is a correspondence between an operating frequency f of the resonator 110 (or an optical waveguide formed by the resonator 110) and a cross-sectional diameter Cd of the metal connector. For example, the correspondence may include but is not limited to:

$$f \geq 1.841c/2 \times \pi \times Cd,$$

where c represents the speed of light.

In addition, the depth Ls of the resonant cavity 112 needs to meet a quarter-wavelength resonance condition, that is, a deviation between Ls and 0.25×λd is within a preset range (which can be set according to a specific application scenario or application requirement), where λd is a wavelength of the electromagnetic signal. That is, Ls=λd, or Ls≈λd.

B. Redistribution layer (redistribution layer, RDL) 120

Redistribution may also be referred to as pad redistribution, indicating that leads of the chip needs to be redistributed to increase lead spacing and meet requirements of a flip chip bonding process.

As shown in FIG. 2, the RDL 120 includes an RDL bottom metal layer 122, an RDL dielectric layer 124, and an RDL top metal layer 126 that are arranged through stacking.

The RDL bottom metal layer 122 and the RDL top metal layer 126 are made of metal.

The RDL bottom metal layer 122 is arranged on the top surface 1102 of the resonator 110 (that is, on an open end surface of the resonator 110 on which the resonant cavity 112 is arranged.)

The RDL dielectric layer 124 is located between the RDL bottom metal layer 122 and the RDL top metal layer 126. By way of example and not limitation, a material of the RDL dielectric layer 124 may be, for example, polyetheretherketone.

It should be understood that the foregoing listed material of the RDL dielectric layer 124 is merely an example for description, and the material of the RDL dielectric layer 124 may also be the same as a material used in the conventional technology.

A through hole is formed on the RDL bottom metal layer 122, and a shape of the through hole is corresponding to a shape of the resonant cavity 112 (or a shape of the metal connector). For example, the through hole is formed as a circle. In addition, a size of the through hole is corresponding to (for example, the same as or approximately the same as) a size of the resonant cavity 112 (or a size of the metal connector). For example, a diameter of the through hole is Ld. In addition, a circle center of the through hole and a circle center of the resonant cavity 112 (specifically, a cross section of the resonant cavity 112) are coaxially arranged.

In addition, an opening for connecting the through hole of the RDL bottom metal layer 122 and the outer wall of the RDL bottom metal layer 122 is arranged on one side wall of the RDL bottom metal layer 122. A width of the opening is not particularly limited in this application, provided that the feeder 140 described below can pass through.

Similarly, a through hole is formed on the RDL top metal layer 126, and a shape of the through hole is corresponding to the shape of the resonant cavity 112 (or the shape of the metal connector). For example, the through hole is formed as a circle. In addition, a size of the through hole is corresponding to (for example, the same as or approximately the same as) a size of the resonant cavity 112 (or a size of the metal connector). In addition, a circle center of the through hole and a circle center of the resonant cavity 112 (specifically, a cross section of the resonant cavity 112) are coaxially arranged.

C. Radiator 130

The radiator 130 is made of metal and is formed into a centro-symmetric shape, and specifically includes a plurality of resonance arms, where the plurality of resonance arms are symmetrically arranged with respect to a symmetry center. For example, as shown in FIG. 2 and FIG. 6, the radiator 130 may be formed into a "cross" shape.

As shown in FIG. 2, the radiator 130 is on a surface that is of the RDL dielectric layer 124 and that faces the RDL bottom metal layer 122.

A symmetry center of the radiator 130 and a symmetry center of the resonant cavity 112 (in other words, a symmetry center of the metal connector) are coaxially arranged. That is, the radiator 130 is located within a range of the through hole of the RDL bottom metal layer 122. That is, the radiator 130 is located within a range of the resonant cavity 112.

It should be understood that the foregoing listed structure of the radiator 130 shown in FIG. 2 and FIG. 6 is merely an example for description, and this application is not limited thereto.

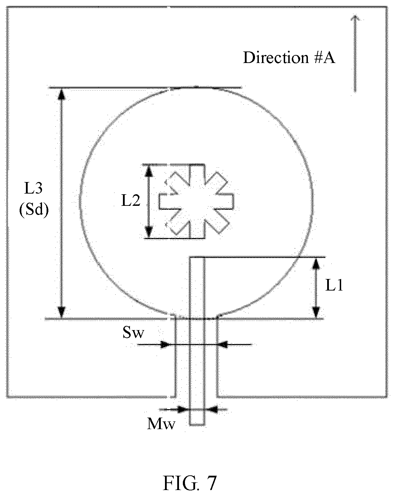

For example, as shown in FIG. 7, the radiator 130 may alternatively be formed into a "double-X" shape.

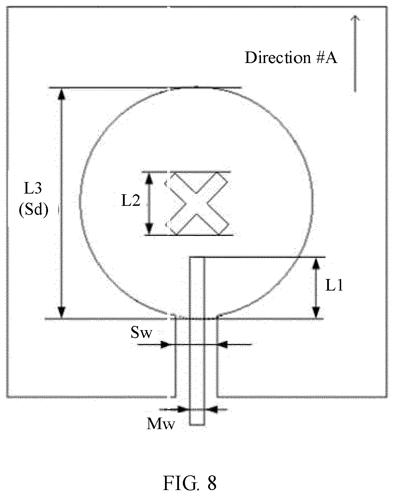

For example, as shown in FIG. 8, the radiator 130 may alternatively be formed into a "X" shape.

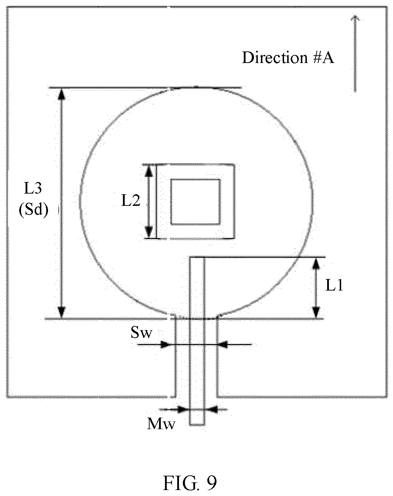

For example, as shown in FIG. 9, the radiator 130 may alternatively be formed into a "rectangular ring shaped" shape.

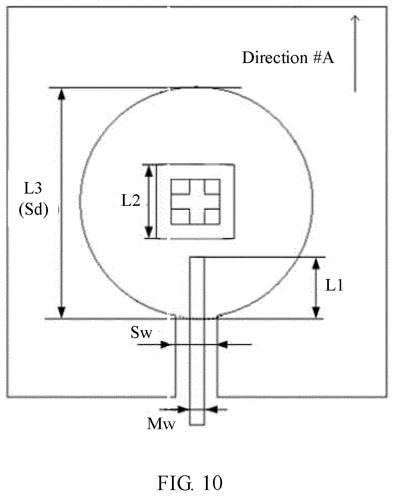

For example, as shown in FIG. 10, the radiator 130 may alternatively be formed into a "2x2 grid" shape.

D. Feeder 140

The feeder 140 is arranged in the groove 114 (and the opening of the RDL bottom metal layer 122), or the feeder 140 passes through the space of the groove 114. Therefore, one end of the feeder 140 is inserted into the resonant cavity 112.

In addition, the other end of the feeder 140 is connected to the chip 200, so that the feeder 140 can transmit an electromagnetic signal between the chip 200 and the coupling structure 100.

The following describes dimensions of the feeder 140.

FIG. 6 to FIG. 10 show an arrangement relationship between the radiator 130, the feeder 140, and the resonant cavity 112. As shown in FIG. 6 to FIG. 10, it is assumed that the feeder 140 is inserted into the resonant cavity 112 along a direction #A, or that the groove 114 is arranged along the direction #A. In addition, it is assumed that a length of a part that is of the feeder 140 and that is inserted into the resonant cavity 112 is L1, a length of the radiator 130 in the direction #A is L2, and a length of the resonant cavity 112 (or a diameter of the resonant cavity) in the direction #A is L3.

To reduce the reflection coefficient, L1, L2, and L3 may meet the following relationship:

$$L1 + 0.5 \times L2 < 0.5 \times L3.$$

It should be understood that the foregoing listed relationship between L1, L2, and L3 is merely an example for description, and this application is not limited thereto. A person skilled in the art may randomly set or change L1, L2, and L3 according to an actual requirement, provided that it is ensured that the signal quality of the electromagnetic signal transmitted between the chip 200 and the coupling structure 100 meets the use requirements.

FIG. 11 shows an example of an arrangement relationship between a PCB, a radio frequency chip, and a metal connector. As shown in FIG. 11, a through hole for accommodating the resonator 110 is formed on the PCB, and a metal plate is arranged at a bottom of the through hole, where the metal plate is configured to seal the bottom of the resonant cavity 112. A depth Ls of the resonant cavity 112, a height Dd of the solder ball on the PCB, and a thickness St of the PCB meet the following requirement:

$$Ls \geq Dd + St.$$

FIG. 12 shows an example of an arrangement relationship between a PCB, a radio frequency chip, and a metal connector. As shown in FIG. 12, a groove for accommodating the resonator 110 is formed on the PCB, and a metal layer is formed at a bottom of the groove, where the metal layer is configured to seal the bottom of the resonant cavity 112. A depth Ls of the resonant cavity 112, a height Dd of the solder ball on the PCB, and a depth thickness St' of the groove on the PCB meet:

$$Ls \geq Dd + St'.$$

By way of example and not limitation, in a possible implementation, the polymer transmission cable is of a solid core structure, a material is selected as polytetrafluoroethylene, a relative permittivity εr of the polymer transmission cable on a D band is 2.1, and a loss angle tangent Df is 0.0002. The polymer transmission cable has a diameter Od of 2 mm, and the polymer transmission cable is inserted into a metal connector through a tapered gradient structure. A diameter Cd of the metal connector is 1.65 mm, and a diameter Td of the through hole 310 for accommodating the metal connector that is formed on the packaging structure 300 (or a diameter of the resonant cavity 112) is 1.65 mm. A thickness of the RDL top metal layer is 0.007 mm, a thickness Sh of the RDL intermediate dielectric layer is 0.05 mm, a thickness of the RDL bottom metal layer is 0.007 mm, a material of the RDL intermediate dielectric layer is polyetheretherketone, a relative permittivity εr of the RDL intermediate dielectric layer is 3.2, and a loss angle tangent Df is 0.004. A width Mw of the feeder 140 = 0.1 mm, a width Sw of the groove 114 = 0.3 mm, and a length L1 of a part that is of the feeder 140 and that extends into the resonant cavity 112 is 0.42 mm. The radiator 130 is formed as a cross patch in a cross shape, an arm length L2 of the cross patch is 0.53 mm, and an arm width Ct of the cross patch is 0.1 mm. The depth Ls of the resonant cavity 112 is 0.45 mm. The PCB material is Rogers5800, and the thickness St of the PCB is 0.254 mm.

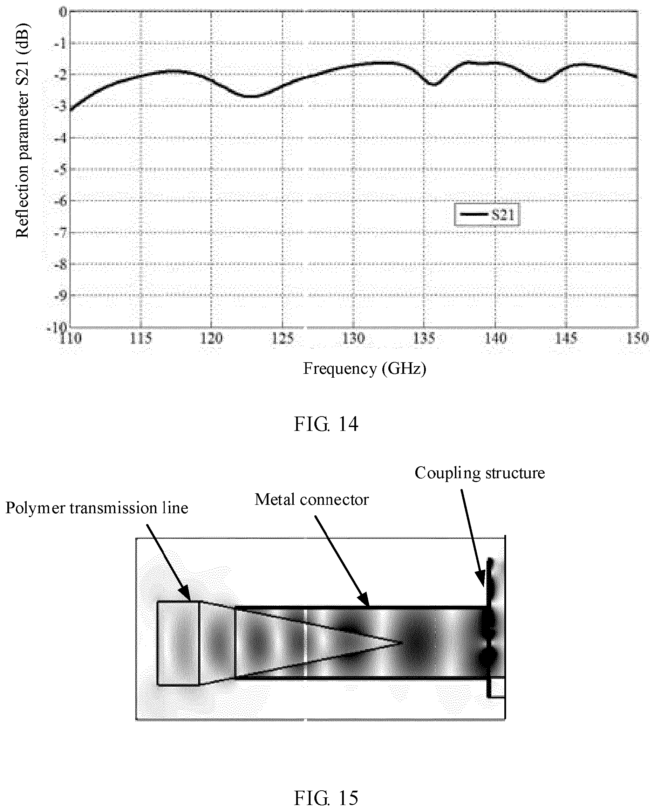

FIG. 13 is a schematic diagram of a relationship between a reflection parameter and a frequency of a radio frequency chip according to this application; and FIG. 14 is a schematic diagram of a relationship between transmission energy and a frequency of a radio frequency chip according to this application. In an electromagnetic simulation experiment, electromagnetic simulation calculation is performed based on the foregoing structural dimensions. An S parameter on the D band (D-band) of this coupling structure solution may be obtained, as shown in FIG. 13 and FIG. 14. It can be learned from the calculation result that, on a frequency band of 110-150 GHz, the reflection parameter S11 is less than -10 dB, and the transmission parameter S21 is greater than -3.05 dB. This indicates that the solution in this application has good electromagnetic transmission performance, and a good electromagnetic coupling effect can be implemented.

FIG. 15 is a schematic diagram of electric field distribution of a coupling structure according to this application. An electric field distribution simulation experiment is performed based on the foregoing structural dimensions, and a calculation result is shown in FIG. 15. It can be learned from FIG. 15 that, a high-frequency signal is coupled to the feed microstrip line on the redistribution layer by using through-silicon vias on the radio frequency chip, and the transmission mode is quasi-TEM mode; the radiator 130 (that is, a metal cross patch antenna) and the resonant cavity 112 convert the quasi-TEM mode into a TE11 mode; and then the metal connector converts the TE11 mode into an HE11 mode.

That is, according to the solution provided in this application, a centro-symmetric radiator is designed at the redistribution layer of the chip, and a through hole for embedding the metal connector is arranged on the packaging structure of the chip, so that a signal generated by the chip can be efficiently coupled to the polymer transmission line. Because the foregoing structure is packaged in the chip, an insertion loss generated due to a connection line arranged between the chip and the coupling structure can be reduced, thereby improving coupling efficiency; and integration between the chip and the coupling structure can be improved, thereby facilitating large-scale processing.

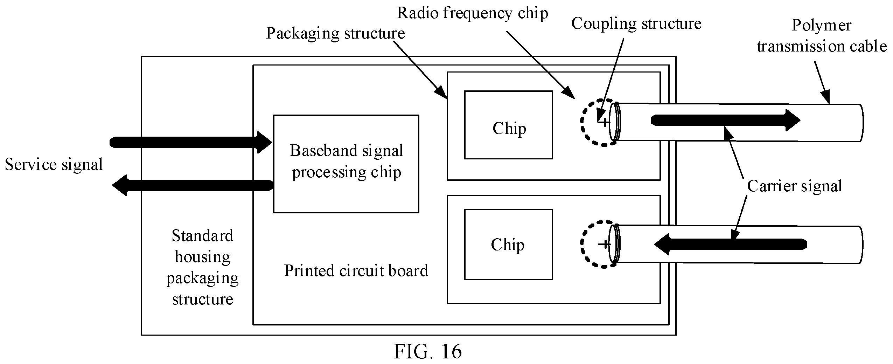

FIG. 16 is a schematic diagram of an example of a signal transceiver to which a radio frequency chip according to this application is applicable. As shown in FIG. 16, the signal transceiver includes a plurality of radio frequency chips, and at least one of the plurality of radio frequency chips has the structure of the radio frequency chip shown in any one of FIG. 1 to FIG. 12. Herein, to avoid repetition, detailed descriptions are omitted. In addition, when the signal transceiver includes a plurality of radio frequency chips according to this application, structures of the plurality of radio frequency chips may be the same or may be different. This is not particularly limited in this application.

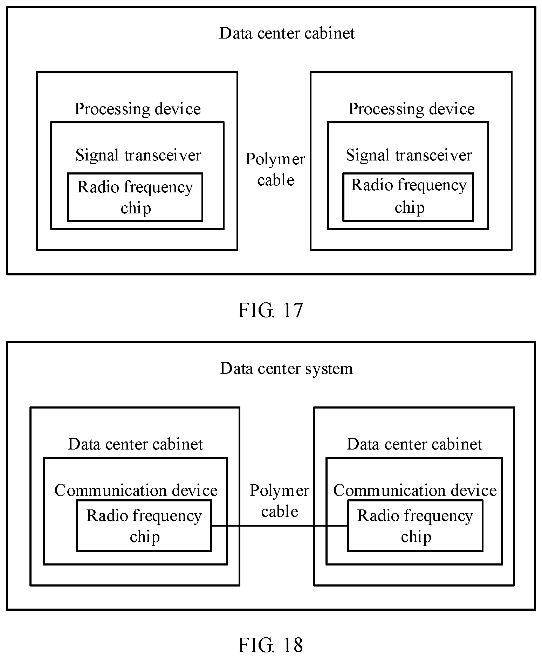

FIG. 17 is a schematic diagram of a structure of an example of a data center cabinet to which a radio frequency chip according to this application is applicable.

As shown in FIG. 17, the data center cabinet includes a plurality of processing devices (for example, boards); each processing device includes one or more signal transceivers; each signal transceiver includes a plurality of radio frequency chips; and at least one radio frequency chip in the plurality of radio frequency chips has the structure of the radio frequency chip shown in any one of FIG. 1 to FIG. 12. Herein, to avoid repetition, detailed descriptions are omitted. In addition, when the signal transceiver includes a plurality of radio frequency chips according to this application, structures of the plurality of radio frequency chips may be the same or may be different. This is not particularly limited in this application.

FIG. 18 is a schematic diagram of a structure of an example of a data center system to which a radio frequency chip according to this application is applicable. As shown in FIG. 18, the data center system includes a plurality of data center cabinets; each data center cabinet includes one or more communication devices or signal transceivers configured to communicate with other data center cabinets; each signal transceiver includes a plurality of radio frequency chips; and at least one radio frequency chip in the plurality of radio frequency chips has the structure of the radio frequency chip shown in any one of FIG. 1 to FIG. 12. Herein, to avoid repetition, detailed descriptions are omitted. In addition, when the signal transceiver includes a plurality of radio frequency chips according to this application, structures of the plurality of radio frequency chips may be the same or may be different. This is not particularly limited in this application.

In the several embodiments provided in this application, it should be understood that the disclosed system and apparatus may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be indirect couplings or communication connections through some interfaces, apparatuses or units, and may be implemented in electrical, mechanical, or other forms.

The units described as separate parts may or may not be physically separate, and parts displayed as units may or may not be physical units, in other words, may be located in one position, or may be distributed on a plurality of units. Some or all of the units may be selected based on actual requirements to achieve the objectives of the solutions of embodiments.

**Claims**

**1.**　An apparatus comprising a radio frequency chip, a metal connector, and a polymer transmission cable, the radio frequency chip comprising:

a chip (200), configured to generate an electromagnetic signal or process an electromagnetic signal;
a coupling structure (100), comprising:

a resonator (110), wherein a resonant cavity (112) and a groove (114) are formed, an inner wall of the resonant cavity (112) is made of metal, one end of the resonant cavity (112) is open on a top surface (1102) of the resonator (110), the other end of the resonant cavity is sealed by a metal material, a cross section of the resonant cavity (112) is formed into a centrosymmetric shape, and the groove (114) connects an outer wall of the resonator (110) and an inner wall of the resonant cavity (112);
a redistribution layer, RDL (120), arranged above the top surface (1102) and comprising an RDL dielectric layer (124);
a radiator (130), made of metal, formed into a centro-symmetric shape, arranged on a surface that is of the RDL dielectric layer (124) and that faces the resonator (110), and accommodated in the resonant cavity (112);
a feeder (140), accommodated in the groove (114), wherein one end is connected to the chip (200), and the other end is inserted into the resonant cavity (112); and
a packaging structure (300), configured to package the chip (200) and cover the redistribution layer RDL (120), wherein a through hole (310) for accommodating the metal connector is formed on the packaging structure (300), one end of the metal connector is in contact with a surface that is of the RDL (120) and that faces away from the resonator (110), the other end of the metal connector is configured to connect to the polymer transmission cable, and a cross section of the through hole (310) is formed into a centro-symmetric shape; and
a symmetry center of the radiator (130), a symmetry center of the resonant cavity (112), and a symmetry center of the through hole (310) are coaxially arranged, and a deviation between cross-sectional sizes of the through hole (310) and the resonant cavity (112) is within a first preset range.

2. The apparatus according to claim 1, wherein a deviation between a depth of the resonant cavity (112) and a first value is within a second preset range, and the first value is a quarter of a wavelength of the electromagnetic signal.

3. The apparatus according to claim 2, wherein the feeder (140) is inserted into the resonant cavity (112) in a first direction; and

a length L1 of a first part that is of the feeder (140) and that is inserted into the resonant cavity (112) is determined based on a length L2 of the radiator (130) in the first direction and a length L3 of the resonant cavity (112) in the first direction; or
L2 is determined based on L1 and L3; or
L3 is determined based on L1 and L2.

4. The apparatus according to claim 3, wherein the length L1, the length L2, and the length L3 meet the following relationship:

$$L1+0.5{\times}L2{<}0.5{\times}L3.$$

5. The apparatus according to any one of claims 1 to 4, wherein the resonator (100) is made of a waveguide material, and an operating frequency f of the waveguide material depends on the cross-sectional diameter D1 of the metal connector.

6. The apparatus according to claim 3, wherein the operating frequency f and the cross-sectional diameter D1 meet the following relationship:

$$f{\geq}1.841c/\,(2{\times}\pi{\times}D1)$$

wherein c represents the speed of light.

7. The apparatus according to any one of claims 1 to 6, wherein a depth of the resonant cavity (112) is greater than or equal to a sum of a second value and a third value, wherein the second value is a depth of a recessed structure that is in a printed circuit board PCB and that is configured to accommodate the coupling structure (100), and the second value is a height of a solder ball in the PCB.

8. The apparatus according to any one of claims 1 to 7, wherein a cross section of the resonant cavity (112) and a cross section of the metal connector are circular, and a deviation between a diameter of the resonant cavity and a diameter of the metal connector is within a third preset range.

9. The apparatus according to any one of claims 1 to 8, wherein the radiator (130) is formed into one of a cross structure, a double-X-shaped structure, an X-shaped structure, a rectangular ring shaped structure, or a 2x2 grid structure.

**10.** A signal transceiver, comprising:

the apparatus according to any one of claims 1 to 9; and
a printed circuit board PCB, provided with a recessed structure for accommodating the radio frequency chip.

**11.** The signal transceiver according to claim 10, wherein the recessed structure is a through hole or a groove.

**12.** A communication device, comprising:
the signal transceiver according to claim 10 or 11.

**Patentansprüche**

**1.** Vorrichtung, einen Hochfrequenz-Chip, einen Metallverbinder und ein Polymerübertragungskabel umfassend,
wobei der Hochfrequenz-Chip Folgendes umfasst:

einen Chip (200), der dafür konfiguriert ist, ein elektromagnetisches Signal zu erzeugen oder ein elektromagnetisches Signal zu verarbeiten, eine Kopplungsstruktur (100), Folgendes umfassend:

einen Resonator (110), wobei ein resonanter Hohlraum (112) und eine Rille (114) gebildet sind, eine Innenwand des resonanten Hohlraums (112) aus Metall besteht, ein Ende des resonanten Hohlraums (112) an einer Oberseite (1102) des Resonators (110) offen ist, das andere Ende des resonanten Hohlraums durch ein Metallmaterial abgedichtet ist, ein Querschnitt des resonanten Hohlraums (112) in einer zentrosymmetrischen Gestalt gebildet ist und die Rille (114) eine Außenwand des Resonators (110) und eine Innenwand des resonanten Hohlraums (112) verbindet,
eine Umverteilungsschicht, RDL, (120), angeordnet über der Oberseite (1102) und eine dielektrische RDL-Schicht (124) umfassend,
einen Radiator (130), der aus Metall besteht, in einer zentrosymmetrischen Gestalt gebildet ist, auf einer Oberfläche angeordnet ist, die zur dielektrischen RDL-Schicht (124) gehört und die zum Resonator (110) weist, und untergebracht in dem resonanten Hohlraum (112),
eine Zuführung (140), untergebracht in der Rille (114), wobei ein Ende mit dem Chip (200) verbunden ist und das andere Ende in den resonanten Hohlraum (112) eingesetzt ist, und
eine Gehäusestruktur (300), die dafür konfiguriert ist, den Chip (200) einzuhäusen und die Umverteilungssicht, RDL, (120) abzudecken, wobei in der Gehäusestruktur (300) eine Durchgangsöffnung (310) zum Unterbringen des Metallverbinders gebildet ist, ein Ende des Metallverbinders in Kontakt mit einer Oberfläche steht, die zur RDL (120) gehört und die weg von dem Resonator (110) weist, das andere Ende des Metallverbinders dafür konfiguriert ist, mit dem Polymerübertragungskabel zu verbinden, und ein Querschnitt der Durchgangsöffnung (310) in einer zentrosymmetrischen Gestalt gebildet ist, und
ein Symmetriezentrum des Radiators (130), ein Symmetriezentrum des resonanten Hohlraums (112) und ein Symmetriezentrum der Durchgangsöffnung (310) koaxial angeordnet sind und eine Abweichung zwischen Querschnittsgrößen der Durchgangsöffnung (310) und des resonanten Hohlraums (112) innerhalb eines ersten voreingestellten Bereichs liegt.

**2.** Vorrichtung nach Anspruch 1, wobei eine Abweichung zwischen einer Tiefe des resonanten Hohlraums (112) und einem ersten Wert innerhalb eines zweiten voreingestellten Bereichs liegt und der erste Wert ein Viertel einer Wellenlänge des elektromagnetischen Signals beträgt.

**3.** Vorrichtung nach Anspruch 2, wobei die Zuführung (140) in einer ersten Richtung in den resonanten Hohlraum (112) eingesetzt ist und

eine Länge L1 eines ersten Teils, der zu der Zuleitung (140) gehört und der in den resonanten Hohlraum (112) eingesetzt ist, basierend auf einer Länge L2 des Radiators (130) in der ersten Richtung und einer Länge L3 des resonanten Hohlraums (112) in der ersten Richtung bestimmt wird und
L2 basierend auf L1 und L3 bestimmt wird oder L3 basierend auf L1 und L2 bestimmt wird.

**4.** Vorrichtung nach Anspruch 3, wobei die Länge L1, die Länge L2 und die Länge L3 das folgende Verhältnis erfüllen:

$$L1 + 0,5 * L2 < 0,5 * L3.$$

**5.** Vorrichtung nach einem der Ansprüche 1 bis 4, wobei der Resonator (100) aus einem Wellenleitermaterial besteht und eine Betriebsfrequenz f des Wellenleitermaterials von dem Querschnittsdurchmesser D1 des Metallverbinders abhängt.

6. Vorrichtung nach Anspruch 3, wobei die Betriebsfrequenz f und der Querschnittsdurchmesser D1 das folgende Verhältnis erfüllen:

$$f \geq 1{,}841c \,/\, (2 * \pi * D1),$$

wobei c die Lichtgeschwindigkeit darstellt.

7. Vorrichtung nach einem der Ansprüche 1 bis 6, wobei eine Tiefe des resonanten Hohlraums (112) größer oder gleich einer Summe eines zweiten Wertes und eines dritten Wertes ist, wobei der zweite Wert eine Tiefe einer vertieften Struktur ist, die sich in einer Leiterplatte, PCB, befindet und die dafür konfiguriert ist, die Kopplungsstruktur (100) unterzubringen, und der zweite Wert eine Höhe einer Lotkugel in der PCB ist.

8. Vorrichtung nach einem der Ansprüche 1 bis 7, wobei ein Querschnitt des resonanten Hohlraums (112) und ein Querschnitt des Metallverbinders kreisförmig sind und eine Abweichung zwischen einem Durchmesser des resonanten Hohlraums und einem Durchmesser des Metallverbinders innerhalb eines dritten voreingestellten Bereichs liegen.

9. Vorrichtung nach einem der Ansprüche 1 bis 8, wobei der Radiator (130) in einem von einer Kreuzstruktur, einer Struktur in Form eines Doppel-X, einer X-förmigen Struktur, einer Struktur in Form eines Rechteckrings oder einer 2x2-Gitterstruktur gebildet ist.

10. Signal-Sendeempfänger, Folgendes umfassend:

die Vorrichtung nach einem der Ansprüche 1 bis 9 und
eine Leiterplatte, PCB, die mit einer vertieften Struktur zum Unterbringen des Hochfrequenz-Chips versehen ist.

11. Signal-Sendeempfänger nach Anspruch 10, wobei die vertiefte Struktur eine Durchgangsöffnung oder eine Rille ist.

12. Kommunikationsgerät, Folgendes umfassend:
den Signal-Sendeempfänger nach Anspruch 10 oder 11.

**Revendications**

1. Appareil comprenant une puce radiofréquence, un connecteur métallique et un câble de transmission polymère, la puce radiofréquence comprenant :

une puce (200) configurée pour générer un signal électromagnétique ou traiter un signal électromagnétique ;
une structure de couplage (100), comprenant :

un résonateur (110), dans lequel sont formées une cavité résonante (112) et une rainure (114), une paroi interne de la cavité résonante (112) est constituée de métal, une extrémité de la cavité résonante (112) est ouverte sur une surface supérieure (1102) du résonateur (110), l'autre extrémité de la cavité résonante est scellée par un matériau métallique, une section transversale de la cavité résonante (112) est formée suivant une forme centro-symétrique, et la rainure (114) relie une paroi externe du résonateur (110) et une paroi interne de la cavité résonante (112) ;
une couche de redistribution, RDL (120), disposée au-dessus de la surface supérieure (1102) et comprenant une couche diélectrique RDL (124) ;
un élément rayonnant (130), constitué de métal, formé suivant une forme centro-symétrique, disposé sur une surface qui est une surface de la couche diélectrique RDL (124) et qui fait face au résonateur (110), et reçu dans la cavité résonante (112) ;
une alimentation (140), logée dans la rainure (114), dans lequel une extrémité est connectée à la puce (200), et l'autre extrémité est insérée dans la cavité résonante (112) ; et
une structure d'emballage (300), configurée pour emballer la puce (200) et recouvrir la couche de redistribution RDL (120), dans lequel un trou traversant (310) destiné à recevoir le connecteur métallique est formé sur la structure d'emballage (300), une extrémité du connecteur métallique est en contact avec une surface qui est une surface de la RDL (120) et qui fait face à l'opposé du résonateur (110), l'autre extrémité du connecteur métallique est conçue pour se connecter au câble de transmission polymère, et une section transversale du trou traversant (310) est formée suivant une forme centro-symétrique ; et
un centre de symétrie de l'élément rayonnant (130), un centre de symétrie de la cavité résonante (112) et un centre de symétrie du trou traversant (310) sont disposés de manière coaxiale, et un écart entre des dimensions en coupe transversale du trou traversant (310) et de la cavité résonante (112) se trouve dans une première plage prédéfinie.

2. Appareil selon la revendication 1, dans lequel un écart entre une profondeur de la cavité résonante (112) et une première valeur se trouve dans une deuxième plage prédéfinie, et la première valeur est égale à un quart d'une longueur d'onde du signal électromagnétique.

3. Appareil selon la revendication 2, dans lequel l'alimentation (140) est insérée dans la cavité résonante (112) dans une première direction ; et

    une longueur L1 d'une première partie qui est une première partie de l'alimentation (140) et qui est insérée dans la cavité résonante (112) est déterminée sur la base d'une longueur L2 de l'élément rayonnant (130) dans la première direction et d'une longueur L3 de la cavité résonante (112) dans la première direction ; ou L2 est déterminée sur la base de L1 et L3 ; ou L3 est déterminée sur la base de L1 et L2.

4. Appareil selon la revendication 3, dans lequel la longueur L1, la longueur L2 et la longueur L3 satisfont la relation suivante :

$$L1 + 0{,}5 \text{ x } L2 < 0{,}5 \text{ x } L3.$$

5. Appareil selon l'une quelconque des revendications 1 à 4, dans lequel le résonateur (100) est constitué d'un matériau de guide d'onde, et une fréquence de fonctionnement f du matériau de guide d'onde dépend du diamètre en coupe transversale D1 du connecteur métallique.

6. Appareil selon la revendication 3, dans lequel la fréquence de fonctionnement f et le diamètre en coupe transversale D1 satisfont la relation suivante :

$$f \geq 1{,}841c/(2 \text{ x } \pi \text{ x } D1)$$

où c représente la vitesse de la lumière.

7. Appareil selon l'une quelconque des revendications 1 à 6, dans lequel une profondeur de la cavité résonante (112) est supérieure ou égale à une somme d'une deuxième valeur et d'une troisième valeur, dans lequel la deuxième valeur est une profondeur d'une structure évidée qui est une carte de circuit imprimé, PCB, et qui est configurée pour recevoir la structure de couplage (100), et la troisième valeur est une hauteur d'une bille de soudure dans la PCB.

8. Appareil selon l'une quelconque des revendications 1 à 7, dans laquelle une section transversale de la cavité résonante (112) et une section transversale du connecteur métallique sont circulaires, et un écart entre un diamètre de la cavité résonante et un diamètre du connecteur métallique se trouve dans une troisième plage prédéfinie.

9. Appareil selon l'une quelconque des revendications 1 à 8, dans lequel l'élément rayonnant (130) est formé suivant l'une d'une structure transversale, d'une structure en forme de double X, d'une structure en forme de X, d'une structure en forme d'anneau rectangulaire ou d'une structure en grille 2x2.

10. Émetteur-récepteur de signal, comprenant :

    l'appareil selon l'une quelconque des revendications 1 à 9 ; et
    une carte de circuit imprimé, PCB, pourvue d'une structure évidée destinée à recevoir la puce radiofréquence.

11. Émetteur-récepteur de signal selon la revendication 10, dans lequel la structure évidée est un trou traversant ou une rainure.

12. Dispositif de communication, comprenant :
    l'émetteur-récepteur de signal selon la revendication 10 ou 11.

Radio frequency chip

Packaging structure 300

Chip 200

Coupling structure 100

Metal connector

Polymer transmission cable

FIG. 1

Resonator 110
Top surface 1102
Resonant cavity 112
RDL bottom metal layer 122
RDL dielectric layer 124
RDL top metal layer 126
Packaging structure 300
Through hole 310
Metal connector
Polymer transmission cable

Metal plate
PCB
Groove 114
Feeder 140
Radiator 130

FIG. 2

FIG. 3

Metal material    Resonant cavity 112    Resonator 110

FIG. 4

Metal material    Resonant cavity 112          Resonator 110

Ls

## FIG. 5

Direction #A

L3
(Sd)

L2

L1

Sw

Mw

## FIG. 6

FIG. 7

FIG. 8

FIG. 9

Direction #A

L3
(Sd)

L2

L1

Sw

Mw

FIG. 10

Polymer transmission line

Metal connector

Radiator

Feeder

Packaging structure

Chip

Dd

Redistribution layer

St

Ls

Resonator

Solder ball

Resonant cavity

Metal plate

PCB

FIG. 11

Polymer transmission line

Metal connector

Radiator

Feeder

Packaging structure

Dd

Chip

Redistribution layer

St

Ls

Resonator

Solder ball

Resonant cavity

Metal plate

PCB

FIG. 12

FIG. 13

FIG. 14

FIG. 15

Radio frequency chip

Coupling structure

Polymer transmission cable

Packaging structure

Service signal

Baseband signal processing chip

Chip

Chip

Carrier signal

Standard housing packaging structure

Printed circuit board

FIG. 16

Data center cabinet

Processing device

Signal transceiver

Radio frequency chip

Polymer cable

Processing device

Signal transceiver

Radio frequency chip

FIG. 17

Data center system

Data center cabinet

Communication device

Radio frequency chip

Polymer cable

Data center cabinet

Communication device

Radio frequency chip

FIG. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1367668 A1

- US 20170324135 A1